(19) Europäisches Patentamt
European Patent Office
Office européen des brevets

(11) **EP 1 048 111 B1**

(12) **EUROPÄISCHE PATENTSCHRIFT**

(45) Veröffentlichungstag und Bekanntmachung des Hinweises auf die Patenterteilung:
**12.12.2007 Patentblatt 2007/50**

(21) Anmeldenummer: **99972802.5**

(22) Anmeldetag: **23.09.1999**

(51) Int Cl.:
*H03M 1/06* *(2006.01)*

(86) Internationale Anmeldenummer:
**PCT/DE1999/003046**

(87) Internationale Veröffentlichungsnummer:
**WO 2000/031875 (02.06.2000 Gazette 2000/22)**

(54) **VERFAHREN UND ANORDNUNG ZUR KOMPENSATION VON PHASENVERZÖGERUNGEN**

METHOD AND DEVICE FOR COMPENSATING PHASE DELAYS

PROCEDE ET DISPOSITIF DE COMPENSATION DE RETARDS DE PHASE

(84) Benannte Vertragsstaaten:
**DE FR GB**

(30) Priorität: **23.11.1998 DE 19853897**

(43) Veröffentlichungstag der Anmeldung:
**02.11.2000 Patentblatt 2000/44**

(73) Patentinhaber: **ROBERT BOSCH GMBH**
**70442 Stuttgart (DE)**

(72) Erfinder: **HAMMEL, Christof**
**D-70188 Stuttgart (DE)**

(56) Entgegenhaltungen:
**WO-A-98/23037** **US-A- 4 694 414**
**US-A- 5 168 459**

• **PATENT ABSTRACTS OF JAPAN vol. 016, no. 254 (E-1213), 9. Juni 1992 (1992-06-09) -& JP 04 054815 A (TOSHIBA CORP), 21. Februar 1992 (1992-02-21)**
• **PATENT ABSTRACTS OF JAPAN vol. 1996, no. 08, 30. August 1996 (1996-08-30) -& JP 08 107700 A (MITSUBISHI HEAVY IND LTD), 23. April 1996 (1996-04-23)**
• **HORST CZICHOS: "Hütte Die Grundlagen der Ingenieurwissenschaften" 1991, SPRINGER VERLAG , BERLIN HEIDELBERG NEW YORK * Seite I56 - Seite I63 ***

EP 1 048 111 B1

**Beschreibung**

Die vorliegende Erfindung betrifft ein Verfahren und eine Anordnung zur Kompensation von Phasenverzögerungen nach den Oberbegriffen der Patentansprüche 1 bzw. 8.

Es ist bei zahlreichen technischen Anwendungen notwendig, ein analog vorliegendes Sensorsignal in ein Digitalsignal umzuwandeln. Durch die einzelnen Glieder einer zu diesem Zwecke verwendeten Signalerfassungskette kommt es zu Verzögerungen zwischen dem ursprünglichen Analogsignal und dem weiterzuverarbeitenden Digitalsignal.

Aus der DE-OS 195 14 410 ist eine Einrichtung zur Erfassung einer pulsierenden Größe bekannt, bei der zur Gewährleistung, daß ein Signal ohne Schwingungen erhalten wird, ein elektronischer Filter vorgesehen ist, der als analoge Schaltung aufgebaut ist und wenigstens ein erstes Glied zur Differentiation und Verzögerung sowie ein zweites Glied zur Multiplikation des differenzierten und verzögerten Signals umfaßt und eine Subtraktionsstufe aufweist, in der das gefilterte Signal von dem ungefilterten Signal subtrahiert werden kann, zur Erzeugung eines geglätteten Ausgangssignals. Diese Druckschrift hat als Aufgabe die Glättung eines pulsierenden Eingangssignals, und befaßt sich nicht mit Signalfehlern, die durch Phasenverzögerungen in einer Signalerfassungskette zur Umwandlung eines digitalen in ein analoges Signal entstehen.

In der US 5,168,459 A wird ein analoges Eingangssignal einem Antialiasingfilter und anschließend einem Analog/Digital-Wandler zugeführt. Um die Phasenverzögerung des Antialiasingfilter zu kompensieren, wird das digitale Signal nachbearbeitet. Dabei findet eine Kompensation der durch den Anti-Aliasing-Filter verursachten Phasenverzögerung des Abtastsignals unter Berücksichtigung einer Filterkonstanten des Anti-Aliasing-Filters statt.

Die Aufgabe der vorliegenden Erfindung besteht darin, bei einer Signalverarbeitung durch einen Anti-Aliasing-Filter und anschließend durch ein Abtastglied die gesamte durch die Signalverarbeitung entstehende Phasenverzögerung zu kompensieren.

Diese Aufgabe wird gelöst durch ein Verfahren und eine Anordnung zur Kompensation von Phasenverzögerungen mit den Merkmalen der Patentansprüche 1 bzw. 8.

Erfindungsgemäß ist nun eine einfach zu realisierende, wirksame Kompensation von bei der zeitdiskreten Abtastung eines analogen Ausgangssignals auftretenden Phasenverzögerungen zur Verfügung gestellt. Phasenverzögerungen, welche aufgrund der Signalverarbeitung durch einen Anti-Aliasing-Filter sowie ein Abtastglied entstehen, werden erfindungsgemäß in umgekehrter Reihenfolge ihrer Entstehung wieder kompensiert.

Vorteilhafte Ausgestaltungen der Erfindung sind Gegenstand der Unteransprüche.

Zweckmäßigerweise wird im Falle einer weiteren, durch eine Totzeit verursachten Phasenverzögerung des Abtastsignals, insbesondere durch eine bei einer Weiterverarbeitung des Abtastsignals auftretende Totzeit, durch welche ein totzeitverzögertes Abtastsignal generiert wird, eine Kompensation der durch die Totzeit verursachten Phasenverzögerung des Abtastsignals unter Berücksichtigung der Totzeit und der Abtastperiode des Abtastgliedes zum Erhalt eines totzeitkompensierten Abtastsignals durchgeführt, wobei dieses totzeitkompensierte Abtastsignal den Phasenverschiebungskompensationen gemäß Anspruch 1 zur weiteren Phasenkompensation unterzogen wird. Hiermit können in wirksamer Weise Phasenverzögerungen, welche zwischen der Abtastung des Signals und seiner Weiterverwendung (z.B. in einem Regler bzw. in einer Korrekturfunktion) auftreten, kompensiert werden.

Zweckmäßigerweise wird eine durch das Abtastglied verursachte Phasenverzögerung, welche in der Form

$$\varphi_A = -\omega \cdot \frac{1}{2} \cdot T_A = -2 \cdot \pi \cdot f \cdot \frac{T_A}{2} = -\pi \cdot f \cdot T_A$$ darstellbar ist, wobei f die Signalfrequenz und $T_A$ die Abtastperiode des Abtastgliedes ist, mittels einer linearen Extrapolation durch einen Korrekturwert der Form

$$y_{k,2} = x_k + \frac{1}{2} \cdot (x_k - x_{k-1}) \,,$$ wobei $x_{k-1}$, $x_k$ Werte des Abtastsignals in aufeinanderfolgenden Abtastperioden

$T_{T,k-1}$, $T_{T,k}$ sind, korrigiert. Diese Korrektur ist rechnerisch mit relativ wenig Aufwand durchzuführen und stellt eine sehr gute Kompensation für typische Phasenverzögerungen, welche in Abtastgliedern entstehen, dar.

Zweckmäßigerweise wird ferner eine durch den Anti-Aliasing-Filter verursachte Phasenverzögerung, welche in der Form $\varphi_F = -\arctan(2 \cdot \pi \cdot f \cdot T_F)$ darstellbar ist, wobei $T_F$ die Filterzeitkonstante des Anti-Aliasing-Filters ist, durch einen Korrekturwert der Form $$y_{k,3} = x_k + \frac{T_F}{T_A} \cdot (x_k - x_{k-1}) \,,$$ korrigiert. Auch diese Korrektur ist in unaufwendiger Weise durchzuführen, und kompensiert mit ausreichender Genauigkeit eine durch einen Anti-Aliasing-Filter verursachte Phasenverzögerung.

Gemäß einer vorteilhaften Ausführungsform der Erfindung wird ferner eine durch die Totzeit verursachte Phasenverzögerung, welche in der Form $\varphi_V = -\arctan(2\pi f T_F) - \pi f T_A - 2\pi f T_T$ darstellbar ist, wobei $T_T$ die Totzeit ist, durch einen Korrekturwert der Form $y_{k,1} = x_k\left(1 + \dfrac{T_T}{T_A}\right) - x_{k-1} \cdot \dfrac{T_T}{T_A}$ korrigiert. Anschaulich bedeutet dies, daß der während der Totzeit $T_T$ entstehende Fehler im nachfolgenden Abtastschritt mit inversen Vorzeichen auf das Abtastsignal aufgeschaltet und damit korrigiert wird. Auch diese Kompensation liefert gute Korrekturergebnisse und ist in einfacher Weise durchzuführen.

Zweckmäßigerweise werden die einzelnen Phasenverzögerungskompensationen sukzessive durchgeführt, so daß insgesamt zur Korrektur eines Abtastsignals während einer Abtastperiode Abtastsignale von zwei bzw. drei vorausgehenden Abtastperioden berücksichtigt werden.

Es erweist sich hierbei als vorteilhaft, die einzelnen Phasenverzögerungskompensationen in der umgekehrten Reihenfolge ihrer Entstehung durchzuführen, so daß auch teilkompensierte Signale verfügbar sind.

Gemäß einer bevorzugten Ausführungsform der erfindungsgemäßen Anordnung zur Kompensation von Phasenverzögerungen weisen die Mittel zur Kompensation der durch das Abtastglied bzw. den Anti-Aliasing-Filter bzw. die Weiterverarbeitungstotzeit verursachten Phasenverzögerung jeweils drei parallele Signalübertragungskanäle auf, wobei ein erster Signalübertragungskanal zur Übertragung eines unveränderten Abtastsignals, ein zweiter, ein Multiplizierglied aufweisender Signalübertragungskanal zur Übertragung eines mit einem Faktor multiplizierten Abtastsignals, und ein dritter, ein Verzögerungsglied und ein Multiplizierglied aufweisender Signalübertragungskanal zur Übertragung eines um eine Abtastperiode verzögerten und mit einem Faktor multiplizierten Abtastsignals auf ein Summierglied dient. Mit einer derartigen Struktur ist die erfindungsgemäße Phasenkompensation in schaltungstechnisch einfacher und zuverlässiger Weise realisierbar.

Hierbei erweist es sich als zweckmäßig, daß die Mittel zur Kompensation der durch das Abtastglied bzw. den Anti-Aliasing-Filter bzw. die Weiterverarbeitungstotzeit verursachten Phasenverzögerung derart hintereinander geschaltet sind, daß sich insgesamt ein phasenkompensiertes Ausgangssignal unter Berücksichtigung der nicht kompensierten Abtastsignale der vorausgehenden drei Abtastperioden ergibt.

Gemäß einer weiteren bevorzugten Ausführungsform der erfindungsgemäßen Anordnung weist diese drei seriell geschaltete Verzögerungsglieder, mit diesen und parallel zueinander verschaltete Multiplizierglieder und ein Summierglied zur Addition der Ausgangssignale der Multiplizierglieder zur Realisierung einer Phasenkompensation zum Erhalt eines phasenkompensierten Abtastsignals der Form $U_{S,K}(k) = A \cdot U_T(k) + B \cdot U_T(k-1) + C \cdot U_T(k-2) + D \cdot U_T(k-3)$ auf, wobei $U_T(k-i, i=0,1,2,3)$ das um i Abtastperioden verzögerte, nicht kompensierte Abtastsignal $U_T$ darstellt, und A,B,C,D Systemkonstanten des Signalabtastpfades darstellen. Hiermit ist mit geringem Rechenaufwand eine Realisierung der erfindungsgemäßen Phasenkompensation durchführbar, da die Systemkonstanten A,B,C,D vorbestimmbar sind und nicht regelmäßig neu berechnet werden müssen.

Gemäß einer weiteren bevorzugten Ausgestaltung der erfindungsgemäßen Anordnung weist diese Mittel zum Abschalten der erfindungsgemäßen Phasenkompensation für den Fall, daß eine Änderung des Eingangssignals innerhalb einer Abtastperiode einen Schwellwert überschreitet, auf. Hierdurch kann wirksam vermieden werden, daß bei sehr schnellen Signaländerungen am Eingang der Kompensation starke Schwankungen in dem kompensierten Signal entstehen.

Die vorliegende Erfindung wird nun anhand der beigefügten Zeichnung im einzelnen erläutert. In dieser zeigt

Figur 1     ein Blockschaltbild einer Signalerfassungskette zur Abtastung eines analogen Sensorsignals,

Figur 2     ein Schaubild zur Darstellung der durch eine Abtastung mittels eines Abtastgliedes entstehenden Phasenverzögerung,

Figur 3     ein Schaubild zur Darstellung einer bei einer Weiterverarbeitung durch eine Totzeit entstehenden Signalverzögerung,

Figur 4     ein Schaubild zur Darstellung der erfindungsgemäßen Kompensation der Abtastverzögerung,

Figur 5     ein Blockdiagramm zur Darstellung der Struktur der gesamten Phasenkompensation,

Figur 6     eine bevorzugte Anordnung zur rechnerischen Durchführung der erfindungsgemäßen Phasenkompensation,

Figur 7     eine weitere bevorzugte Anordnung zur rechnerischen Durchführung der erfindungsgemäßen Phasenkompensation,

Figur 8 den Verlauf einer Batteriespannung während eines Startvorgangs eines Kraftfahrzeugs,

Figur 9 den Verlauf der Batteriespannung gemäß Figur 8 nach einer erfindungsgemäßen Phasenkompensation,

Figur 10 einen entsprechenden Stromverlauf mit und ohne erfindungsgemäße Phasenkompensation,

Figur 11 einen simulierten Phasengang einer einen Anti-Aliasing-Filter und ein Abtastglied aufweisenden Signalstrekke ohne erfindungsgemäße Phasenkompensation, und

Figur 12 einen simulierten Phasengang einer einen Anti-Aliasing-Filter und ein Abtastglied aufweisenden Signalstrekke mit erfindungsgemäßer Phasenkompensation.

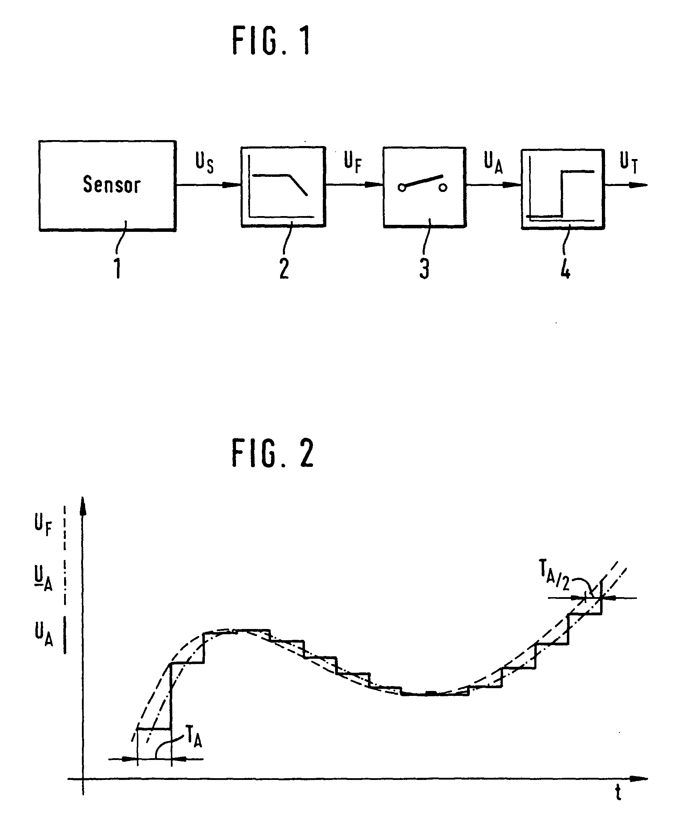

Die einzelnen Glieder einer Signalerfassungskette, welche zur Umwandlung eines analogen Sensorausgangsignals $U_S$ in ein digitales Signal $U_T$ verwendet wird, sind in Figur 1 dargestellt.

Ein Sensor 1 erzeugt das Ausgangssignal $U_S$. Mit 2 ist ein Anti-Aliasing-Filter bezeichnet, welcher zur Vermeidung von Aliasing-Effekten durch eine nachfolgende Abtastung des Signals dient. Der Anti-Aliasing-Filter ist typischerweise als Tiefpaßfilter ausgebildet. Zur Erfüllung des Abtast-Theorems muß die Beziehung $f_g < \frac{1}{2} \cdot f_A$ gelten, wobei $f_g$ die Grenzfrequenz des als Tiefpaß ausgebildeten Anti-Aliasing-Filters 2 und $f_A$ die Abtastfrequenz des nachfolgenden Abtastgliedes 3 ist. Im einfachsten Fall ist dieser Tiefpaßfilter ein PT1-Glied (Proportional-Totzeit-Glied) mit der Übertragungsfunktion $G_{TP}(s) = \dfrac{1}{1 + s \cdot T_F}$. Hierbei ist s die komplexe Frequenzvariable $s = \sigma + j\omega$ und $T_F$ die Filterzeitkonstante. Die Phasenverzögerung eines derartigen Tiefpaßfilters beträgt $\varphi_F = -\arctan(2 \cdot \pi \cdot f \cdot T_F)$. Das Ausgangssignal des Anti-Aliasing-Filters 2 ist mit $U_F$ bezeichnet.

In dem dem Anti-Aliasing-Filter 2 nachgeschalteten Abtastglied bzw. Sample-Glied 3 werden die Signalwerte zu diskreten Zeitpunkten $t = k \cdot T_A$ abgetastet, wobei $k = 0, 1, 2, 3, ...$, und $T_A$ die Abtastperiode des Abtastgliedes 3 ist. Das Ausgangssignal des Abtastgliedes ist mit $U_A$ bezeichnet. In Figur 2 ist das Prinzip der Abtastung dargestellt. Es ist zu erkennen, daß die mittlere Spannung $\underline{U}_A$ des Signals $U_A$ gegenüber $U_F$ um die halbe Abtastperiode verzögert ist.

Die Phasenverzögerung ergibt sich daher zu $\varphi_A = -\omega \cdot \dfrac{1}{2} \cdot T_A = -2 \cdot \pi \cdot f \cdot \dfrac{T_A}{2} = -\pi \cdot f \cdot T_A$.

Das Signal $U_A$ stellt das eigentlich zur Weiterverarbeitung vorgesehene digitale Signal dar. Es kommt jedoch aufgrund von Verzögerungen zwischen dem Abtast-Task und einer nachgeschalteten Task, beispielsweise einer Regler-Task, zu einer Zeitverzögerung zwischen der Abtastung und der Weiterverwendung des Signalwertes $U_A$ (Totzeit zwischen der Abtastung und einer nachgeschalteten Funktion). Diese Phasenverzögerung beträgt $\varphi_T = -\omega \cdot T_T = -2 \cdot \pi \cdot f \cdot T_T$. Das hierdurch schließlich entstehende totzeitverzögerte Signal (Arbeitssignal) ist in Figur 1 mit $U_T$ bezeichnet. Der Abschnitt des Signalerfassungsweges, auf dem es zu dieser Phasenverzögerung kommt, ist symbolisch mit 4 bezeichnet.

Die aufgrund der Signalerfassungsstrecke 2,3,4 entstehende Signalverzögerung des Sensorausgangssignals $U_S$ beträgt daher insgesamt $\varphi_v = -\arctan(2\pi f T_F) - \pi f T_A - 2\pi f T_T$.

Bereits relativ geringe Phasenverzögerungen wirken sich stark auf den Fehler zwischen Analogsignal $U_S$ und Arbeitssignal $U_T$ aus. Sei

$$U_S(t) = \hat{U}_S \cdot \sin(\omega t),$$

so ergibt sich

$$U_T(t) = \hat{U}_T \cdot \sin(\omega t - \varphi_v).$$

$\hat{U}_S$ bzw. $\hat{U}_T$ sind hierbei die Amplituden der Signale $U_S$ bzw. $U_T$.

Der Fehler ergibt sich zu

$$U_e(t) = \hat{U}_S \cdot \sin(\omega t) - \hat{U}_T \cdot \sin(\omega t - \varphi_v).$$

Vereinfachend kann von einer kleinen Signaldämpfung ausgegangen werden, so daß $\hat{U}_T = \hat{U}_S$ gesetzt werden kann. Damit folgt

$$U_e(t) = \hat{U}_S \cdot [\sin(\omega t) - \sin(\omega t - \varphi_v)]$$

$$= 2 \cdot \hat{U}_S \cdot \sin(\varphi_v/2) \cdot \cos(\omega t - \varphi_v/2).$$

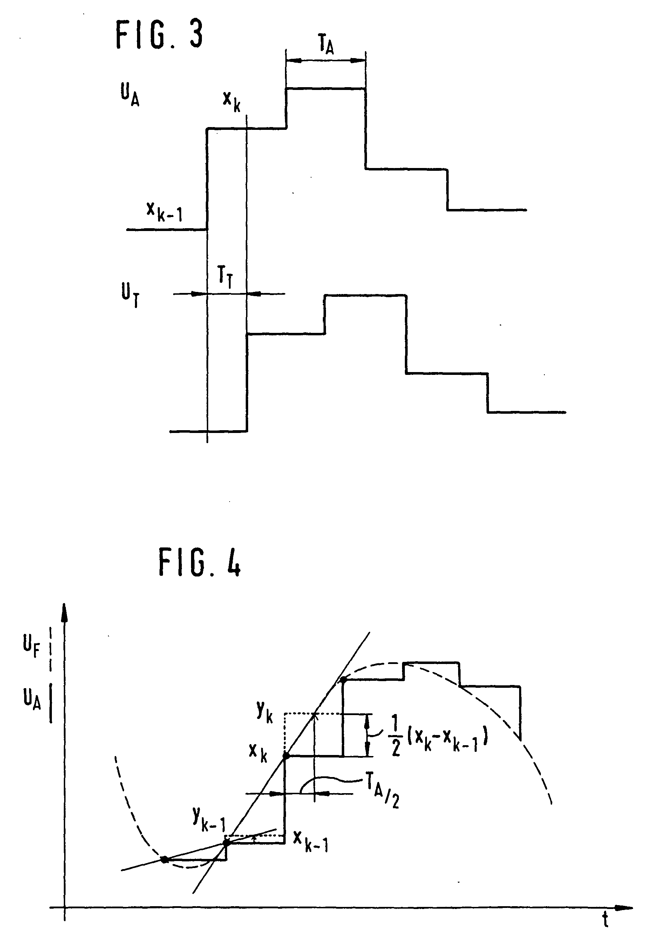

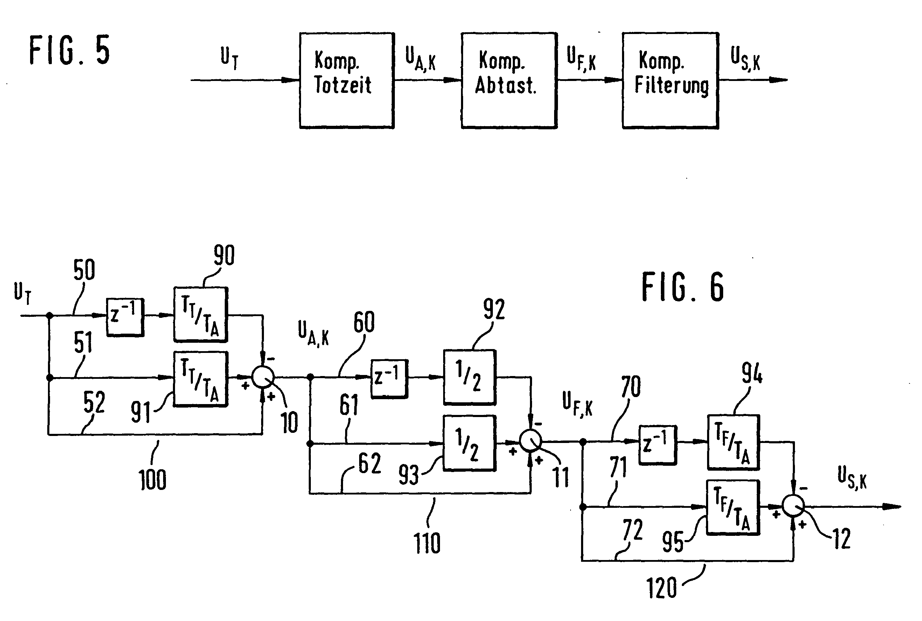

Die Amplitude des Fehlers ist daher durch die Signalamplitude $\hat{U}_S$ und die Phasenverzögerung $\varphi_v$ bestimmt. Eine Verringerung des Fehlers kann jedoch nur durch Reduzierung der Phasenverzögerung erfolgen. Dies ist jedoch häufig aufgrund von begrenzter Rechenleistung des digitalen Prozessorsystems nur in unzureichender Weise möglich.
Die Erfindung strebt nun an, die auftretenden Phasenverzögerungen in möglichst einfacher Weise zu kompensieren.
Erfindungsgemäß wird die Kompensationen für Filterung, Abtastung und Totzeit in umgekehrter Reihenfolge ihrer Ursache in den Signalpfad integriert (siehe Figur 5). Daher wird zunächst eine Kompensation der bei der Weiterverarbeitung des Signals auftretenden Totzeit behandelt. Es wäre möglich, durch Verlagerung des Verarbeitungsprozesses in die Task der Signalerfassung Totzeiten, wie beispielsweise Interrupt-Latenzzeiten, zu minimieren. Dies erfordert jedoch relativ großen Aufwand, so daß erfindungsgemäß angestrebt wird, eine rechnerische Kompensation der durch die Totzeit entstehenden Phasenverzögerung zur Verfügung zu stellen. Die durch die Totzeit bei der Weiterverarbeitung entstehende Signalverzögerung ist in Figur 3 schematisch dargestellt. Mit $x_{k-1}$ bzw. $x_k$ sind in Figur 3 die Signalwerte während der Intervalle $t = k \cdot T_A$ bezeichnet. Es ist zu erkennen, daß ein neuer Wert $x_{k+1}$ mit einer Verzögerung $T_T$ (Totzeit) wirksam wird. Für die Zeit $T_T$ wird mit dem vorhergehenden Wert $x_{k-1}$ gerechnet. Um den hierdurch entstehenden Fehler im nächsten Abtastschritt zu kompensieren, wird der Wert $x_k$ mit dem Anteil $x_{k,kor} = (x_k - x_{k-1}) \cdot \dfrac{T_T}{T_A}$ korrigiert. Damit ergibt sich für das kompensierte Signal $y_k = x_k + x_{k,kor}$ bzw.

$$y_{k1} = x_k \left(1 + \frac{T_T}{T_A}\right) - x_{k-1} \cdot \frac{T_T}{T_A}.$$

Anschaulich bedeutet dies, daß der Fehler, der während der Totzeit $T_T$ gemacht wird, im nachfolgenden Abtastschritt mit inversem Vorzeichen aufgeschaltet und damit korrigiert wird.
Die durch die Abtastung entstehende Phasenverzögerung sowie ihre Korrektur wird nun anhand der Figur 4 dargestellt. Man erkennt in dieser Figur, daß durch die Abtastung das Ausgangssignal $U_F$ des Anti-Aliasing-Filters 2 im Mittel um die Zeit $T_A/2$ verzögert wird. Ziel der Kompensation ist es hier, zum Zeitpunkt t den Wert zum Zeitpunkt $t + T_A/2$ vorauszuberechnen. Dies erfolgt zweckmäßigerweise durch eine lineare Extrapolation der Form

$$s\left(t + \frac{T_A}{2}\right) \cong s(t) + \frac{1}{2} \cdot \left[s(t) - s(t - T_A)\right].$$

Als korrigierter Abtastwert wird durch die erfindungsgemäße Kompensation der folgende Wert ausgegeben:

$$y_{k2} = x_k + \frac{1}{2} \cdot (x_k - x_{k-1}) \, .$$

Im folgenden wird schließlich die Kompensation der durch Verwendung eines Anti-Aliasing-Filters entstehenden Phasenverzögerung im einzelnen erläutert.

Ein als PT1-Filter ausgeführter Anti-Aliasing-Filter besitzt die Übertragungsfunktion

$$G_F(s) = \frac{1}{1 + sT_F} \, .$$

Das Übertragungsverhalten von $G_F$ kann kompensiert werden durch die inverse Funktion

$$G_F^I(s) = 1 + sT_F \, .$$

Diese zeitkontinuierliche Übertragungsfunktion kann in eine zeitdiskrete Differenzengleichung überführt werden: Die Sprungantwort von $G_F^I$ ist

$$g_\sigma(t) = \mathfrak{I}^{-1}\left\{ \frac{1}{s} \cdot G_F^I(s) \right\}$$

$$g_\sigma(t) = \mathfrak{I}^{-1}\left\{ \frac{1 + sT_F}{s} \right\}$$

$$g_\sigma(t) = \mathfrak{I}^{-1}\left\{ \frac{1}{s} + T_F \right\}$$

$$g_\sigma(t) = 1 + T_F \cdot \delta(t)$$

Hierbei bezeichnet $\mathfrak{I}^{-1}$ die inverse Laplace-Transformation und $\delta(t)$ die Dirac-Funktion. Die zeitdiskrete Funktion von $g_\sigma(t)$ ist

$$g_\sigma(kT_A) = 1 + T_F \cdot \delta(kT_A)$$

Die z-Transformierte dieser Funktion lautet

$$G_\sigma(z) = \frac{z}{z - 1} + \frac{T_F}{T_A}$$

G$_\sigma$(z) ist die z-Transformierte der Sprungantwort. Das z-Übertragungsverhalten ergibt sich, indem G$_\sigma$(z) durch die z-Transformierte der Sprungfunktion dividiert wird:

$$\sigma(z) = \frac{z}{z-1}$$

Damit folgt:

$$G_F^I(z) = \frac{G_\sigma(z)}{\sigma(z)} = 1 + \frac{z-1}{z} \cdot \frac{T_F}{T_A}$$

$$= \frac{z\left(1 + \frac{T_F}{T_A}\right) - \frac{T_F}{T_A}}{z} = \frac{y(z)}{x(z)}$$

Diese Gleichung kann nach y aufgelöst werden:

$$y(z) = x(z) \cdot \left(1 + \frac{T_F}{T_A}\right) - z^{-1} \cdot \frac{T_F}{T_A} \cdot x(z)$$

Durch Rücktransformation in den Zeitbereich ergibt sich schließlich die Differenzengleichung

$$y_{k3} = x_k + \frac{T_F}{T_A} \cdot (x_k - x_{k-1}).$$

Wie bereits erwähnt, ist erfindungsgemäß vorgesehen, die beschriebenen Kompensationen für Filterung, Abtastung und Totzeit in umgekehrter Reihenfolge ihrer Ursache bzw. Entstehung in den Signalpfad zu integrieren. Durch die beschriebene Totzeit-Kompensation wird ein Signal U$_{A,K}$, die nachgeschaltete Abtastkompensation ein Signal U$_{F,K}$ und die anschließende Filterungs-Kompensation das Ausgangssignal U$_{S,K}$ erzeugt (siehe Figur 5).

Ein Blockschaltbild zur Realisierung dieser Kompensationsfunktionen ist in Figur 6 dargestellt. Man erkennt drei seriell hintereinander geschaltete Phasenkompensationsschaltblöcke 100, 110, 120, welche jeweils drei parallele Signalübertragungskanäle 50, 51, 52, 60, 61, 62 und 70, 71, 72 aufweisen. Hierin sind mit z$^{-1}$ Verzögerungsglieder bezeichnet, welche ein eintretendes Signal um eine Abtastperiode T$_A$ verzögern. Mit 90-95 sind Multiplizierglieder bezeichnet, welche Multiplikationen mit den jeweils dargestellten Faktoren ausführen. Ferner sind Addier- bzw. Subtrahierglieder 10, 11, 12 vorgesehen. Gemäß dieser Realisierung der Kompensationsfunktionen wird das Arbeitssignal U$_T$ zunächst (bei 100) unverändert, mit einem Faktor $\frac{T_T}{T_A}$ multipliziert sowie um eine Abtastperiode verzögert und mit dem Faktor $\frac{T_T}{T_A}$ multipliziert auf das erste Summierglied 10 gegeben. Das Ausgangssignal des Summiergliedes 10, welches dem kompensierten Signal y$_{k1}$ bzw. U$_{A,K}$ entspricht, wird (bei 110) in entsprechender Weise unverändert, mit dem Faktor 1/2, und um eine weitere Abtastperiode verzögert und mit einem Faktor 1/2 multipliziert auf ein zweites Summierglied 11 gegeben. Das Summierglied 11 erzeugt ein dem kompensierten Signal y$_{k2}$ entsprechendes Summensignal. Als Ausgangssignal ergibt sich insgesamt das Signal U$_{F,K}$, welches wiederum (bei 120) in entsprechender Weise, nämlich unverändert, mit einem Faktor $\frac{T_T}{T_A}$ multipliziert und um eine weitere Abtastperiode verzögert und mit dem Faktor $T_T/T_A$ multipliziert, auf einen dritten Summierer 12 gegeben wird, welcher ein dem kompensierten Signal $y_{k3}$ entsprechendes Signal erzeugt. Das Ausgangssignal des Summiergliedes 12, $U_{S,K}$, stellt das endgültig kompensierte Ausgangssignal gemäß der Erfindung dar.

Für die Berechnung dieser Kompensation ergibt sich damit die folgende Gleichung:

$$
\begin{aligned}
U_{S,K}(k) = {} & U_T(k) \cdot \left[ 1,5 + 1,5 \cdot \frac{T_T}{T_A} + 1,5 \frac{T_F}{T_A} + 1,5 \frac{T_T T_F}{T_A^2} \right] \\
& - U_T(k-1) \cdot \left[ 0,5 + 2 \cdot \frac{T_T}{T_A} + 2 \cdot \frac{T_F}{T_A} + 3,5 \cdot \frac{T_T T_F}{T_A^2} \right] \\
& + U_T(k-2) \cdot \left[ 0,5 \cdot \frac{T_F}{T_A} + 0,5 \cdot \frac{T_T}{T_A} + 2,5 \cdot \frac{T_T T_F}{T_A^2} \right] \\
& - U_T(k-3) \cdot \left[ 0,5 \cdot \frac{T_T T_F}{T_A^2} \right]
\end{aligned}
$$

Die in den Klammern enthaltenen Terme stellen Systemkonstanten des Signalerfassungspfades dar. Die Gleichung läßt sich daher in der Form

$$
U_{S,K}(k) = A \cdot U_T(k) + B \cdot U_T(k-1) + C \cdot U_T(k-2) + D \cdot U_T(k-3)
$$

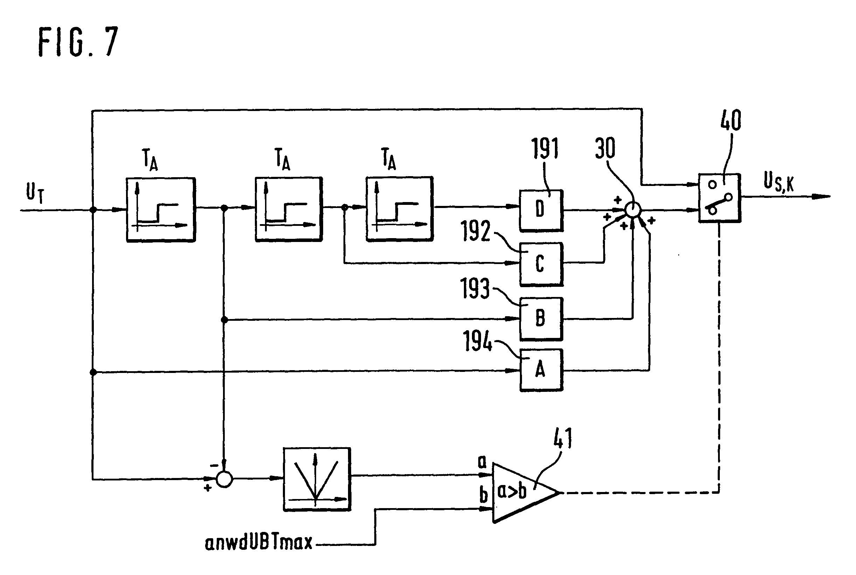

darstellen. Hierbei stellen die Werte $U_T(k-i)$, i=0-3 um i Abtastperioden verzögerte, unkompensierte Signale $U_T$ dar. Eine Gleichung dieser Struktur läßt sich mit der in Figur 7 dargestellten Schaltanordnung in einfacher Weise realisieren. Hier sind der Einfachheit halber mit $T_A$ Verzögerungsglieder, welche ein eingehendes Signal jeweils um eine Abtastperiode verzögern, und mit 191-194 Multiplizierglieder bezeichnet, welche die Werte $U_T(k-i)$ mit den entsprechenden Faktoren A,B,C,D multiplizieren. Die mit den Faktoren A,B,C,D multiplizierten Signale werden in einem Addierglied 30 miteinander multipliziert.

Die in Figur 7 dargestellte Schaltungsanordnung erweist sich als sehr günstig, da hier der notwendige Rechneraufwand zur Durchführung der erfindungsgemäßen Phasenverzögerungskompensation sehr gering ist. Es ist lediglich erforderlich, Signalverzögerungen vorzunehmen und die verzögerten Eingangssignale mit den entsprechenden, durch das System vorgegebenen Konstanten A,B,C,D zu multiplizieren und die erhaltenen Werte zu addieren. Die in Figur 7 dargestellte Schaltungsanordnung ist sowohl in Hardware- als auch Softwareausführung in sehr preiswerter Weise realisierbar.

Um zu verhindern, daß bei sehr schnellen Signaländerungen am Eingang der Kompensationsschaltung gemäß Figur 7 starke Schwankungen in dem kompensierten Signal entstehen, wird die Korrektur abgeschaltet (Schalter 40), wenn die Änderung des Eingangssignals $U_T$ innerhalb eines Abtastschrittes einen Schwellwert (anwdUBTmax) überschreitet. Ein Vergleich der Änderung des Eingangssignals mit dem Schwellwert wird hierbei in einem Komparator 41 vorgenommen.

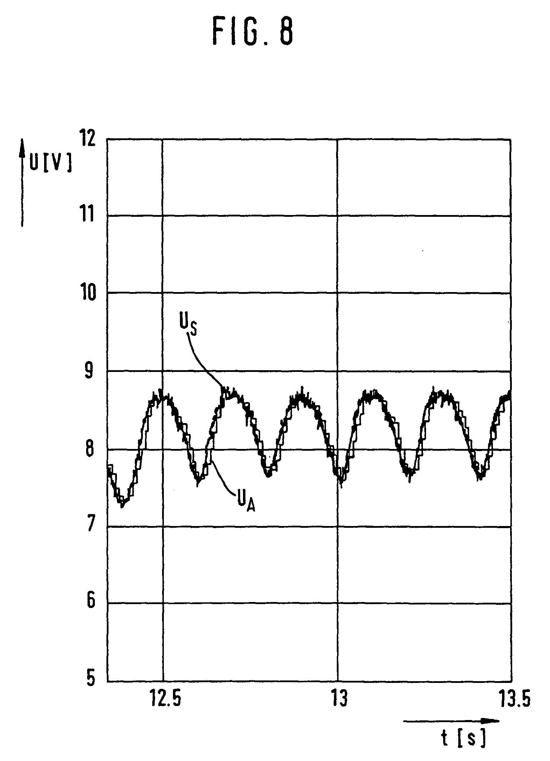

Eine typische Anwendung der erfindungsgemäßen Phasenkompensation wird nun unter Bezug auf die Figuren 8 bis 12 im einzelnen dargestellt. Gemäß einer bevorzugten Ausführungsform erfolgt eine Realisierung der erfindungsgemäßen Phasenverzögerungskompensation bei der Erfassung der Batteriespannung, beispielsweise für ein Motorsteuergerät eines Common-Rail-Systems. Mit der Batteriespannung werden u.a. elektrische Stellglieder gespeist, welche Magnetventile ansteuern. Durch Schwankungen in der Batteriespannung kommt es zu Schwankungen des Magnetventilstromes. Um diesen Einfluß zu verringern, wird eine Batteriespannungskorrektur durchgeführt, welche den Stellwert entsprechend der aktuellen Batteriespannung nach oben oder unten korrigiert. Durch Signalverzögerungen in der Batteriespannungserfassung wird jedoch diese Korrekturfunktion stark beeinträchtigt. Das bedeutet, daß Schwankungen der Batteriespannung selbst mit Korrektur zu einer Stromschwankung führen. Mit der dargestellten erfindungsgemäßen Kompensation kann diese Stromschwankung stark minimiert werden. Dies führt z.B. auch zu einem glatteren Raildruckverlauf in einem Common-Rail-System.

In Figur 8 ist die Batteriespannung in der Startphase eines Kraftfahrzeuges gegen die Zeit aufgetragen (Signal $U_S$). Ein durch Abtastung erhaltenes digitales Signal (ohne erfindungsgemäße Phasenkompensation) ist in Figur 8 ebenfalls dargestellt (Signal $U_A$).

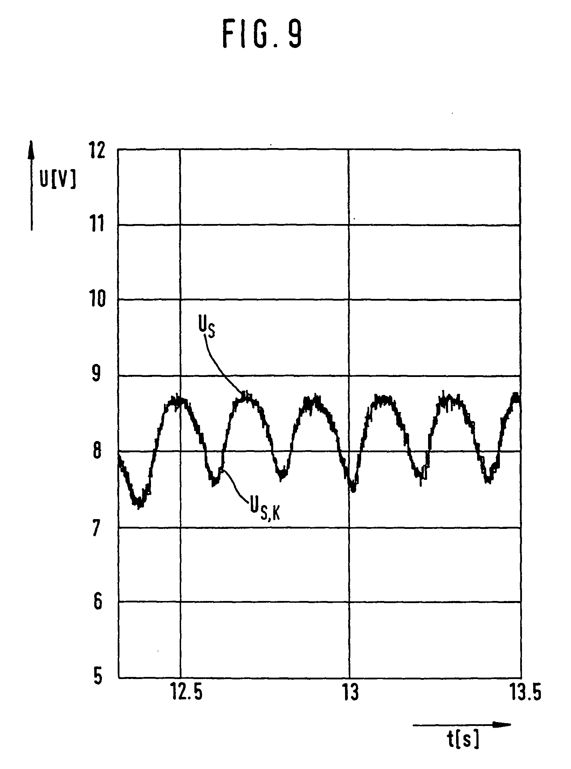

In Figur 9 ist das Signal $U_S$ zusammen mit einem erfindungsgemäß phasenkompensierten Signal $U_{S,K}$ dargestellt. Man erkennt, daß mittels der erfindungsgemäßen Phasenkompensation eine wesentlich genauere Annäherung an das Spannungsausgangssignal der Batterie ($U_S$) erzielbar ist.

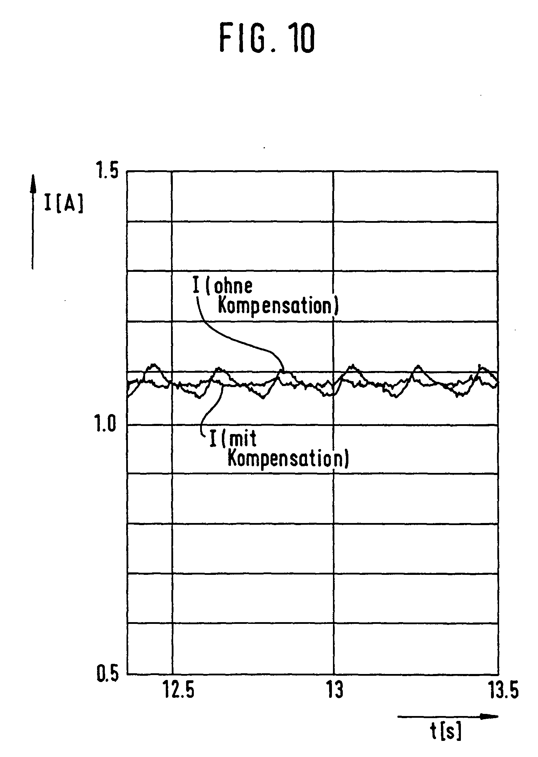

In Figur 10 ist ein Magnetventilstrom I in Abhängigkeit von den dargestellten Batteriespannungsverläufen $U_A$ (ohne Kompensation) und $U_{S,K}$ (mit Kompensation) gegen die Zeit aufgetragen. Es ist zu erkennen, daß der mit der erfindungsgemäßen Phasenkompensation zur Verfügung gestellte Magnetventilstrom wesentlich geringere Schwankungen aufweist.

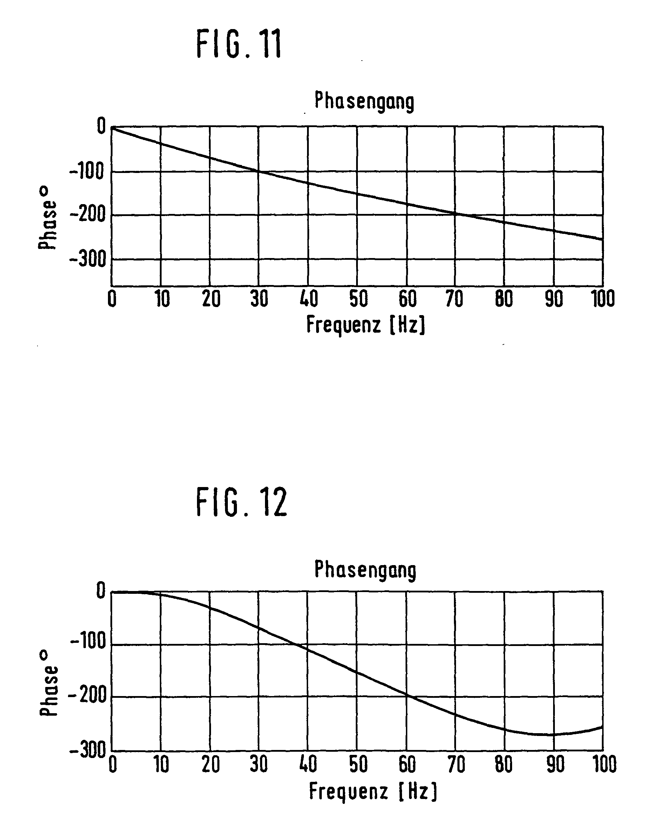

Unter Bezugnahme auf die Figuren 11 und 12 wird die erfindungsgemäße Phasenverzögerungskompensation weiter erläutert. Es wurde hierbei eine Simulation der Signale durchgeführt, welche bei einer Signalerfassungsstrecke mit einem Anti-Aliasing-Filter und einem Abtastglied entstehen. Hierbei wurde eine Filterzeitkonstante $T_F$ des Anti-Aliasing-Filters von 6 ms, und eine Abtastperiode $T_A$ des Abtastgliedes von 10 ms angenommen. Figur 11 zeigt den ohne die erfindungsgemäße Phasenkompensation auftretenden Phasengang. Man erkennt, daß bereits bei geringen Frequenzen (ab 1 Hz) merkliche Phasenverzögerungen auftreten:

In Figur 12 ist nun der Phasengang der erfindungsgemäßen phasenkompensierten Signalstrecke, also der Signalstrecke Anti-Aliasing-Filter, Abtastglied, Kompensation des Anti-Aliasing-Filters, und Kompensation des Abtastgliedes dargestellt. Man erkennt, daß bis zu Frequenzen von etwa 7 bis 8 Hz eine im wesentlichen vollständige Kompensation der auftretenden Phasenverzögerungen möglich ist. Beim Startvorgang auftretende Batteriespannungsschwankungen, welche typischerweise im Bereich von 5 bis 8 Hz liegen, können hiermit in sehr effektiver Weise kompensiert werden. Aus den Figuren 11, 12 erkennt man, daß die erfindungsgemäße Phasenkompensation eine Phasenanhebung und damit eine Aufhebung der auftretenden Totzeiten verursacht.

**Patentansprüche**

1. Verfahren zur Kompensation von bei einer zeitdiskreten Abtastung eines analogen Ausgangssignals ($U_s$) auftretenden Phasenverzögerung, wobei das analoge Ausgangssignal ($U_s$) einer Signalverarbeitung durch einen Anti-Aliasing-Filter (2) und anschließend durch ein Abtastglied (3) zum Erhalt eines eine Abtastperiode (T) aufweisenden Abtastsignals ($U_A$) unterzogen wird, wobei die durch den Anti-Aliasing-Filter verursachte Phasenverzögerung des Abtastsignals unter Berücksichtigung einer Filterkonstanten des Anti-Aliasing-Filters kompensiert wird, **gekennzeichnet durch** folgende Schritte:

   - Kompensation einer **durch** das Abtastglied (3) verursachten Phasenverzögerung des Abtastsignals unter Berücksichtigung des Abtastsignals der vorausgehenden Abtastperiode zum Erhalt eines ersten Signals ($U_{F,K}$), und
   - anschließend Kompensation der **durch** den Anti-Aliasing-Filter (2) verursachten Phasenverzögerung des Abtastsignals unter Berücksichtigung einer Filterkonstanten ($T_F$) des Anti-Aliasing-Filters, der Abtastperiode ($T_A$) des Abtastgliedes (3) und des Abtastsignals der vorausgehenden Abtastperiode zum Erhalt eines phasenkompensierten Signals ($U_{S,K}$).

2. Verfahren nach Anspruch 1, **dadurch gekennzeichnet, daß** im Falle einer weiteren Phasenverzögerung des Abtastsignals ($U_A$), insbesondere durch eine bei einer Weiterverarbeitung des Abtastsignals auftretenden Totzeit ($T_T$), durch welche ein totzeitverzögertes Abtastsignal ($U_T$) generiert wird, eine Kompensation der durch die Totzeit verursachten Phasenverzögerung des totzeitverzögerten Abtastsignals ($U_T$) unter Berücksichtigung der Totzeit ($T_T$), der Abtastperiode des Abtastgliedes und des Abtastsignals der vorausgehenden Abtastperiode zum Erhalt eines totzeitkompensierten Abtastsignals ($V_{A,K}$) durchgeführt wird, wobei das totzeitkompensierte Abtastsignal ($U_{A,K}$) den Phasenverschiebungskompensationen gemäß dem Anspruch 1 zur weiteren Phasenkompensation unterzogen wird.

3. Verfahren nach Anspruch 1 oder 2, **dadurch gekennzeichnet, daß** eine durch das Abtastglied (3) verursachte Phasenverzögerung, welche in der Form $\varphi_A = -\omega \cdot \dfrac{1}{2} \cdot T_A = -2 \cdot \pi \cdot f \cdot \dfrac{T_A}{2} = -\pi \cdot f \cdot T_A$ darstellbar ist, wobei f die Signalfrequenz und $T_A$ die Abtastperiode des Abtastgliedes (3) ist, mittels einer linearen Extrapolation durch einen Korrekturwert der Form $y_{k,2} = x_k + \frac{1}{2} \cdot (x_k - x_{k-1})$, wobei $x_{k-1}$, $x_k$ Werte des Abtastsignals in aufeinanderfolgenden Abtastperioden $T_{T,k-1}$, $T_{T,k}$ sind, korrigiert wird.

4. Verfahren nach einem der vorstehenden Ansprüche, **dadurch gekennzeichnet, daß** eine durch den Anti-Aliasing-Filter (2) verursachte Phasenverzögerung, welche in der Form $\varphi_F = -\arctan(2 \cdot \pi \cdot f \cdot T_F)$ darstellbar ist, wobei $T_F$ die Filterzeitkonstante des Anti-Aliasing-Filters ist, durch einen Korrekturwert der Form

$$y_{k,3} = x_k + {T_F}\big/{T_A} \cdot (x_k - x_{k-1}) \,, \quad \text{korrigiert wird.}$$

5. Verfahren nach einem der Ansprüche 2 bis 4, **dadurch gekennzeichnet, daß** eine durch die Totzeit ($T_T$) verursachte Phasenverzögerung, welche in der Form $\varphi_v = -\arctan(2\pi f T_F) - \pi f T_A - 2\pi f T_T$ darstellbar ist, durch einen Korrekturwert der Form $y_{k,1} = x_k \left(1 + \dfrac{T_T}{T_A}\right) - x_{k-1} \cdot \dfrac{T_T}{T_A}$ korrigiert wird.

6. Verfahren nach einem der vorstehenden Ansprüche, **dadurch gekennzeichnet, daß** die einzelnen Phasenverzögerungskompensationen sukzessive durchgeführt werden, so daß insgesamt zur Korrektur eines Abtastsignals ($U_A$, $U_T$) während einer Abtastperiode Abtastsignale von zwei bzw. drei vorausgehenden Abtastperioden berücksichtigt werden.

7. Verfahren nach einem der vorstehenden Ansprüche, **dadurch gekennzeichnet, daß** die einzelnen Phasenverzögerungskompensationen in der umgekehrten Reihenfolge ihrer Entstehung durchgeführt werden.

8. Anordnung zur Kompensation von bei einer zeitdiskreten Abtastung eines analogen Ausgangssignals ($U_s$) auftretenden Phasenverzögerung, wobei das analoge Ausgangssignal ($U_s$) einer Signalverarbeitung durch einen Anti-Aliasing-Filter (2) und anschließend durch ein Abtastglied (3) zum Erhalt eines Abtastsignals ($U_A$) unterzogen wird, wobei erste Mittel (120; 191-194, 30, $z^{-1}$) vorgesehen sind, mittels der die durch den Anti-Aliasing-Filter verursachte Phasenverzögerung des Abtastsignals unter Berücksichtigung einer Filterkonstanten des Anti-Aliasing-Filters kompensiert wird, **gekennzeichnet**

   - **durch** zweite Mittel (110; 191-194, 30, $z^{-1}$) zur Kompensation einer durch das Abtastglied (3) verursachten Phasenverzögerung des Abtastsignals unter Berücksichtigung des Abtastsignals der vorausgehenden Abtastperiode zum Erhalt eines ersten Signals ($U_{F,K}$), wobei
   - die zweiten Mittel (120; 191-194, 30, $z^{-1}$) zur anschließenden Kompensation der durch den Anti-Aliasing-Filter (2) verursachten Phasenverzögerung des Abtastsignals unter Berücksichtigung einer Filterkonstanten ($T_F$) des Anti-Aliasing-Filters, der Abtastperiode ($T_A$) des Abtastgliedes (3) und des Abtastsignals der vorausgehenden Abtastperiode zum Erhalt eines phasenkompensierten Signals ($U_{S,K}$) vorgesehen sind.

9. Anordnung nach Anspruch 8, **gekennzeichnet durch** Mittel (120; 191-194, 30, $z^{-1}$) zur Kompensation einer **durch** eine bei einer Weiterverarbeitung des Abtastsignals auftretenden Totzeit ($T_T$) verursachten Phasenverzögerung des Abtastsignals, **durch** welche ein totzeitverzögertes Abtastsignal ($U_T$) erhalten wird, unter Berücksichtigung der Totzeit ($T_T$), der Abtastperiode ($T_A$) und dem Abtastsignal der vorausgehenden Abtastperiode zum Erhalt eines totzeitkompensierten Abtastsignals ($U_{A,K}$), und Mittel zur Zuführung dieses totzeitkompensierten Abtastsignals ($U_{A,K}$) zu den Mitteln zur Phasenverschiebungs-Kompensation gemäß Anspruch 8 zur weiteren Phasenkompensation.

10. Anordnung nach einem der Ansprüche 8 oder 9, **dadurch gekennzeichnet, daß** die ersten, zweiten oder dritten Mittel (100, 110, 120) zur Kompensation der durch das Abtastglied (3) bzw. den Anti-Aliasing-Filter (2) bzw. die Weiterverarbeitungstotzeit ($T_T$) verursachten Phasenverzögerung jeweils eine Anzahl paralleler Signalübertragungskanäle (50, 51, 52; 60, 61, 62; 70, 71, 72) aufweisen, wobei ein erster Signalübertragungskanal (52, 62, 72) zur Übertragung eines unveränderten Abtastsignals, ein zweiter, ein Multiplizierglied (91, 93, 95) aufweisender Signalübertragungskanal (51; 61; 71) zur Übertragung eines mit einem Faktor multiplizierten Abtastsignals, und ein dritter, ein Verzögerungsglied ($z^{-1}$) und ein Multiplizierglied (90, 92, 94) aufweisender Signalübertragungskanal (50, 60, 70) zur Übertragung eines um eine Abtastperiode verzögerten und mit einem Faktor multiplizierten Abtastsignals auf ein Summierglied (10 ; 11; 12) dient.

11. Anordnung nach Anspruch 10, **dadurch gekennzeichnet, daß** die ersten, zweiten oder dritten Mittel (100, 110, 120) zur Kompensation der durch das Abtastglied (3) bzw. den Anti-Aliasing-Filter (2) bzw. die Weiterverarbeitungstotzeit ($T_T$) verursachten Phasenverzögerung derart hintereinander geschaltet sind, daß sich insgesamt ein phasenkompensiertes Ausgangssignal ($U_{S,K}$) unter Berücksichtigung der nicht komperisierten totzeitverzögerter Abtastsignale ($U_T$) der vorausgehenden drei Abtastperioden ergibt.

12. Anordnung nach Anspruch 9, **gekennzeichnet durch** eine Anzahl seriell geschalteter Verzögerungsglieder ($z^{-1}$), mit diesen und parallel zueinander verschaltete Multiplizierglieder (191-194) und ein Summierglied (30) zur Addition der Ausgangssignale der Multiplizierglieder (191-194) zur Realisierung einer Phasenkompensation zum Erhalt eines phasenkompensierten Abtastsignals ($U_{S,K}$) der Form $U_{S,K}(k) = A \cdot U_T(k)+B \cdot U_T(k-1)+C \cdot U_T(k-2)+D \cdot U_T(k-3)$ wobei $U_T$ (k-i,i=0,1,2,3) das um i Abtastperioden verzögerte, nicht kompensierte Abtastsignal ($U_T$) darstellt, und A,B,C,D Systemkonstanten des Signalabtastpfades darstellen.

13. Anordnung nach Anspruch 12, **gekennzeichnet durch** vierte Mittel (40, 41) zum Abschalten der Phasenkompensation für den Fall, daß eine Änderung des nicht kompensierten Abtastsignal ($U_T$) innerhalb einer Abtastperiode einen Schwellwert (anwdUBTmax) überschreitet.

## Claims

1. Method for compensating for a phase delay which occurs in the case of discrete-time sampling of an analogue output signal ($U_S$), with the analogue output signal ($U_S$) being subjected to signal processing by means of an anti-aliasing filter (2) and then by means of a sampling element (3) in order to obtain a sample signal ($U_A$) which has a sample period (T), with the phase delay caused by the anti-aliasing filter in the sample signal being compensated for by taking into account a filter constant of the anti-aliasing filter, **characterized by** the following steps:

   - compensation for a phase delay caused by the sampling element (3) in the sample signal taking into account the sample signal from the previous sampling period in order to obtain a first signal ($U_{F,K}$), and
   - subsequent compensation for the phase delay caused by the anti-aliasing filter (2) in the sample signal taking into account a filter constant ($T_F$) of the anti-aliasing filter, the sampling period ($T_A$) of the sample element (3) and of the sample signal from the previous sampling period in order to obtain a phase-compensated signal ($U_{S,K}$).

2. Method according to Claim 1, **characterized in that**, in the event of a further phase delay to the sample signal ($U_A$), in particular as a result of a dead time ($T_T$) which occurs during further processing of the sample signal and which results in a sample signal ($U_T$) delayed by the dead time being generated, the phase delay, which is caused by the dead time, to the sample signal ($U_T$) which has been delayed by the dead time is compensated for taking into account the dead time ($T_T$), the sampling period of the sampling element and the sample signal from the previous sampling period in order to obtain a dead-time-compensated sample signal ($U_{A,K}$), with the dead-time-compensated sample signal ($U_{A,K}$) being subject to the phase shift compensation processes according to Claim 1, for further phase compensation.

3. Method according to Claim 1 or 2, **characterized in that** a phase delay which is caused by the sampling element (3) and can be represented in the form where f is the signal frequency and $T_A$ is the sampling period of the sampling element (3), is corrected by means of a linear extrapolation using a correction value in the form

$$y_{k,2} = x_k + \frac{1}{2} \cdot (x_k - x_{k-1}) \,,$$

where $x_{k-1}$, $x_k$ are values of the sample signal in successive sampling periods $T_{T,k-1}$, $T_{T,k}$.

4. Method according to one of the preceding claims, **characterized in that** a phase delay which is caused by the anti-aliasing filter (2) and can be represented in the form $\varphi_F = -arctan(2 - \pi \cdot f \cdot T_F)$, while $T_P$ is the filter time constant of the anti-aliasing filter, is corrected by a correction value in the form $y_{k,3} = x_k + \dfrac{T_F}{T_A} \cdot (x_k - x_{k-1})$ .

**5.** Method according to one of Claims 2 to 4, **characterized in that** a phase delay which is caused by the dead time $(T_T)$ and can be represented in the form $\varphi_y = -arctan\ (2\pi f T_F) - \pi f T_A - 2\pi f T_T$ is corrected by a correction value in the form $y_{k,1} = x_k(1 + \dfrac{T_T}{T_A}) - x_{k-1} \cdot \dfrac{T_T}{T_A}$ .

**6.** Method according to one of the preceding claims, **characterized in that** the individual phase delay compensations are carried out successively so that sample signals from two or three preceding sampling periods are taken into account in total for correcting a sample signal $(U_A, U_T)$ during one sampling period.

**7.** Method according to one of the preceding claims, **characterized in that** the individual phase delay compensations are carried out in the opposite sequence to that in which they are created.

**8.** Arrangement for compensating for a phase delay which occurs during discrete-time sampling of an analogue output signal $(U_S)$, with the analogue output signal $(U_S)$ being subjected to signal processing by an anti-aliasing filter (2) and then by a sampling element (3) in order to obtain a sample signal $(U_A)$, with first means (120; 191-194, 30, $z^{-1}$) being provided, by means of which the phase delay caused by the anti-aliasing filter in the sample signal is compensated for taking into account a filter constant of the anti-aliasing filter, **characterized**

- **by** second means (110 ; 191-194, 30, $z^{-1}$) for compensating for a phase delay caused by the sampling element (3) in the sample signal, taking into account the sample signal from the preceding sampling period in order to obtain a first signal $(U_{F,K})$, with
- the second means (120; 191-194, 30, $z^{-1}$) being provided for subsequent compensation for the phase delay, which is caused by the anti-aliasing filter (2) in the sample signal taking into account a filter constant $(T_F)$ of the anti-aliasing filter, the sampling period $(T_A)$ of the sampling element (3) and the sample signal from the preceding sampling period in order to obtain a phase-compensated signal $(U_{S,K})$.

**9.** Arrangement according to Claim 8, **characterized by** third means (120; 191-194, 30, $z^{-1}$) for compensating for a phase delay, which is caused by a dead time $(T_T)$ which occurs during further processing of the sample signal, to the sample signal by means of which a sample signal $(U_T)$ which has been delayed by the dead time is obtained, taking into account the dead time $(T_T)$, the sampling period $(T_A)$ and the sample signal from the previous sampling period in order to obtain a dead-time-compensated sample signal $(U_{A,K})$, and means for supplying this dead-time-compensated sample signal $(U_{A,K})$ to the second means for phase-shift compensation according to Claim 8, for further phase compensation.

**10.** Arrangement according to one of Claims 8 or 9, **characterized in that** the first, second or third means (100, 110, 120) for compensating for the phase delay which is caused by the sampling element (3) and/or by the anti-aliasing filter (2) and/or by the further-processing dead time $(T_T)$ in each case have a number of parallel signal transmission channels (50, 51, 52; 60, 61, 62; 70, 71, 72), with a first signal transmission channel (52, 62, 72) being used to transmit an unchanged sample signal, a second signal transmission channel (51; 61; 71), which has a multiplication element (91, 93, 95), being used to transmit a sample signal multiplied by a factor, and a third signal transmission channel (50, 60, 70), which has a delay element $(z^{-1})$ and a multiplication element (90, 92, 94), being used to transmit a sample signal which has been delayed by one sampling period and multiplied by a factor, to an addition element (10; 11; 12).

**11.** Arrangement according to Claim 10, **characterized in that** the first, second or third means (100, 110, 120) for compensating for the phase delay which is caused by the sampling element (3) and/or the anti-aliasing filter (2) and/or the further-processing dead time $(T_T)$ are connected in series in such a manner that, overall, this results in a phase-compensated output signal $(U_{S,K})$ taking into account the uncompensated sample signals $(U_T)$, which have been delayed by the dead time, from the previous three sampling periods.

**12.** Arrangement according to Claim 9, **characterized by** a number of series-connected delay elements $(z^{-1})$, multiplication elements (191-194) connected to them and connected in parallel with one another, and an addition element (30) for the addition of the output signals from the multiplication elements (191-194) in order to provide phase compensation, in order to obtain a phase-compensated sample signal ($U_{S,K}$) in the form $U_{S,K}(k)=A \cdot U_T(k)+B \cdot U_T(k-1)+C \cdot U_T(k-2)+D \cdot U_T(k-3)$ where $U_T$(k-i, i = 0,1,2,3) represents the uncompensated sample signal ($U_T$) delayed by i sampling periods, and A,B,C,D represent system constants of the signal sampling path.

**13.** Arrangement according to Claim 12, **characterized by** fourth means (40, 41) for switching off the phase compensation in the situation where a change in the uncompensated sample signal ($U_T$) exceeds a threshold value (anwdUBTmax) within one sampling period.

## Revendications

**1.** Procédé de compensation d'un retard de phase survenant lors d'un échantillonnage temporel discret d'un signal de sortie analogique ($U_s$), en soumettant le signal de sortie analogique ($U_s$) à un traitement de signal par un filtre anticrénelage (2) puis par un organe d'échantillonnage (3) afin d'obtenir un signal d'échantillonnage ($U_A$) présentant une période d'échantillonnage (T), le retard de phase du signal d'échantillonnage, provoqué par le filtre anticrénelage étant compensé compte tenu d'une constante de filtrage du filtre anticrénelage,
**caractérisé par**
les étapes suivantes :

- compensation d'un retard de phase du signal d'échantillonnage, provoqué par l'organe d'échantillonnage (3), en tenant compte du signal d'échantillonnage de la période d'échantillonnage précédente afin d'obtenir un premier signal ($U_{F,K}$) et
- ensuite compensation du retard de phase du signal d'échantillonnage provoqué par le filtre anticrénelage (2) en tenant compte d'une constante de filtrage ($T_F$), du filtre anticrénelage, de la période d'échantillonnage ($T_A$) de l'organe d'échantillonnage 3) et du signal d'échantillonnage de la période d'échantillonnage précédente afin d'obtenir un signal à phase compensée ($U_{S,K}$).

**2.** Procédé selon la revendication 1,
**caractérisé en ce que**
dans le cas d'un autre retard de phase du signal d'échantillonnage ($U_A$), du en particulier à un temps mort ($T_T$) apparaissant lors d'un retraitement du signal d'échantillonnage et générant un signal d'échantillonnage à temps mort retardé ($U_T$), une compensation du retard de phase provoqué par le temps mort, du signal d'échantillonnage ($U_T$) à temps mort retardé est faite en tenant compte du temps mort ($T_T$), de la période d'échantillonnage de l'organe d'échantillonnage et du signal d'échantillonnage de la période d'échantillonnage précédente, afin d'obtenir un signal d'échantillonnage ($U_{A,K}$) à temps mort compensé, le signal d'échantillonnage ($U_{A,K}$) à temps mort compensé étant soumis aux compensations de décalage de phase selon la revendication 1 pour une autre compensation de phase.

**3.** Procédé selon la revendication 1 ou la revendication 2,
**caractérisé en ce qu'**
on corrige un retard de phase provoqué par l'organe d'échantillonnage (3) et représenté par la formule,

$$\varphi_A = -\omega \cdot \frac{1}{2} \cdot T_A = -2 \cdot \pi \cdot f \cdot \frac{T_A}{2} = -\pi \cdot f \cdot T_A$$

f étant la fréquence du signal et $T_A$ la période d'échantillonnage de l'organe d'échantillonnage (3), au moyen d'une extrapolation linéaire avec une valeur corrective de forme $y_{k,2} = X_k + 1/2 \cdot (x_k - x_{k-1})$, dans laquelle $x_{k-1}$, $x_k$ sont des valeurs du signal d'échantillonnage dans des périodes d'échantillonnage successives $T_{T,k-1}$, $T_{T,k,}$.

**4.** Procédé selon l'une quelconque des revendications précédentes,
**caractérisé en ce qu'**
un retard de phase provoqué par le filtre anticrénelage (2) et pouvant être traduit par $\varphi_F$ = -arctan($2 \cdot \pi \cdot f \cdot T_F$), T étant la constante du temps de filtrage du filtre anticrénelage, est corrigé par une valeur corrective de forme $y_{k,3} = x_k + T_F/T_A \cdot (x_k - x_{k-1})$.

**5.** Procédé selon l'une quelconque des revendications 2 à 4,
**caractérisé en ce qu'**

un retard de phase, provoqué par le temps mort ($T_x$) et pouvant être traduit par $\varphi_y$ = -arctan($2\pi fT_F$) - $\pi fT_A$ - $2\pi fT_r$, est corrigé par une valeur de correction de forme

$$y_{k,1} = x_k \left(1 + \frac{T_T}{T_A}\right) - x_{k-1} \cdot \frac{T_T}{T_A}$$

**6.** Procédé selon l'une quelconque des revendications précédentes,
**caractérisé en ce que**
les différentes compensations des retards de phase sont effectuées l'une après l'autre, de sorte qu'au total on tient compte de signaux d'échantillonnage de deux ou trois périodes d'échantillonnage précédentes pour corriger un signal d'échantillonnage ($U_A$, $U_T$) pendant une période d'échantillonnage.

**7.** Procédé selon l'une des revendications précédentes,
**caractérisé en ce que**
les différentes compensations de retards de phase sont effectuées dan l'ordre inverse de leur apparition.

**8.** Dispositif permettant la compensation d'un retard de phase survenant lors d'un échantillonnage temporel discret d'un signal de sortie analogique ($U_s$), dans lequel le signal de sortie analogique $U_s$ est soumis à un traitement de signal par un filtre anticrénelage (2) puis par un organe d'échantillonnage (3) afin d'obtenir un signal d'échantillonnage ($U_A$), avec des premiers moyens (120 ; 191-194, 30, $z^{-1}$) pour compenser, le retard de phase du signal d'échantillonnage, provoqué par le filtre anticrénelage, en tenant compte d'une constante de filtrage du filtre anticrénelage, **caractérisé par**

- des seconds moyens (110; 191-194, 30, $z^{-1}$) pour compenser un retard de phase du signal d'échantillonnage provoqué par le signal d'échantillonnage (3) en tenant compte du signal d'échantillonnage de la période d'échantillonnage précédente afin d'obtenir un premier signal ($U_{F,K}$),
- les seconds moyens (120; 191-194, 30, $z^{-1}$) étant prévus pour compenser ensuite le retard de phase du signal d'échantillonnage provoqué par le signal anticrénelage (2) en tenant compte d'une constante de filtrage ($T_F$) du filtre anticrénelage, de la période d'échantillonnage ($T_A$) de l'organe d'échantillonnage (3) et du signal d'échantillonnage de la période d'échantillonnage précédente afin d'obtenir un signal à phase compensée $U_{S,K}$).

**9.** Dispositif selon la revendication 8,
**caractérisé par**
des troisièmes moyens (120; 191-194, 30, $z^{-1}$) pour compenser un retard de phase du signal d'échantillonnage, provoqué par un temps mort ($T_T$) survenant lors d'un retraitement du signal d'échantillonnage, et produisant un signal d'échantillonnage à temps mort retardé ($U_T$), en tenant compte du temps mort ($T_T$), de la période d'échantillonnage ($T_A$) et du signal d'échantillonnage de la période d'échantillonnage précédente afin d'obtenir un signal d'échantillonnage ($U_{A,K}$) à temps mort compensé, et des moyens pour l'acheminement de ce signal d'échantillonnage ($U_{A,K}$) à temps mort compensé vers les seconds moyens pour compenser le décalage de phase selon la revendication 8, afin de poursuivre la compensation de phase.

**10.** Dispositif selon l'une quelconque des revendications 8 ou 9,
**caractérisé en ce que**
les premiers, seconds et troisièmes moyens (100, 110, 120) présentent respectivement un nombre de canaux de transmission de signaux parallèles (50, 51, 52 ; 60, 61, 62 ; 70, 71, 72) pour compenser le retard de phase provoqué par l'organe d'échantillonnage (3) ou le filtre anticrénelage (2) ou le temps mort de retraitement ($T_T$), un premier canal de transmission de signaux (52, 62, 72) servant à transmettre un premier signal d'échantillonnage, un deuxième canal de transmission de signaux (51 ; 61 ; 71), présentant un organe multiplicateur (91, 93, 95) servant à transmettre un signal d'échantillonnage inchangé multiplié par un facteur, et un troisième canal de transmission de signaux (50, 60, 70) présentant un organe temporisateur ($z^{-1}$) et un organe multiplicateur (90, 92, 94) servant à transmettre à un organe additionneur (10 ; 11 ; 12) un signal d'échantillonnage temporisé d'une période d'échantillonnage et multiplié d'un facteur.

**11.** Dispositif selon la revendication 10,
**caractérisé en ce que**
les premiers, seconds ou troisièmes moyens (100, 110, 120) sont branchés l'un derrière l'autre pour compenser le retard de phase provoqué par l'organe d'échantillonnage (3) ou par le filtre anticrénelage (2), ou le temps mort de retraitement ($T_T$), de manière à obtenir au total un signal de sortie à phase compensée ($U_{S,K}$) en tenant compte des signaux d'échantillonnage à temps mort retardés non compnsés ($U_T$) des trois périodes d'échantillonnage précédentes.

12. Dispositif selon la revendication 9,
    **caractérisé par**
    plusieurs organes de temporisation ($z^{-1}$) branchés en série, des organes multiplicateurs (191-194) connectés à ceux-ci et en parallèle l'un à l'autre, et un organe additionneur (30) pour additionner les signaux de sortie des organes multiplicateurs (191-194) pour réaliser une compensation de phase ($U_{S,K}$) de forme $U_{S,K}(k) = A \cdot U_T(k) + B \cdot U_T(k-1) + C \cdot U_T(k-2) + D \cdot U_T(k-3)$,
    $U_T(K-i, i = 0, 1, 2, 3)$ étant le signal d'échantillonnage ($U_T$) retardé de i périodes d'échantillonnage et non compensé, et A, B, C, D étant des constantes systèmes du chemin d'échantillonnage du signal.

13. Dispositif selon la revendication 12,
    **caractérisé par**
    des quatrièmes moyens (40, 41) pour déconnecter la compensation de phase pour le cas où une modification du signal d'échantillonnage ($U_T$) non compensé dans les limites d'une période d'échantillonnage dépasse une valeur de seuil (anwdUBTmax).

# FIG. 1

# FIG. 2

FIG. 3

FIG. 4

FIG. 5

$U_T \rightarrow$ | Komp. Totzeit | $\xrightarrow{U_{A,K}}$ | Komp. Abtast. | $\xrightarrow{U_{F,K}}$ | Komp. Filterung | $\xrightarrow{U_{S,K}}$

FIG. 6

FIG. 7

EP 1 048 111 B1

# FIG. 8

# FIG. 9

# FIG. 10

# FIG. 11

# FIG. 12

**EP 1 048 111 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19514410 A

- US 5168459 A